# EUROPEAN PATENT APPLICATION

(11) **EP 4 407 695 A1**
(43) Date of publication of application: **31.07.2024**
(21) Application number: 22897687.4
(22) Date of filing: 17.11.2022
(51) Int. Cl.: H01L 31/18

(54) **SOLAR CELL AND PREPARATION METHOD FOR SOLAR CELL**

(30) Priority: 23.11.2021 CN 202111396218
(71) Applicant: Ja Solar Technology Yangzhou Co., Ltd., Yangzhou, Jiangsu 225131 (CN)
(72) Inventor: JIANG, Xiulin, Yangzhou, Jiangsu 225131 (CN); CHEN, Bin, Yangzhou, Jiangsu 225131 (CN); DUAN, Guangliang, Yangzhou, Jiangsu 225131 (CN)
(74) Representative: Sun, Yiming
(86) International application number: PCT/CN2022/132504
(87) International publication number: WO 2023/093604

(57) **Abstract**

The application discloses a solar cell and a preparation method for a solar cell. The preparation method for a solar cell comprises: sequentially forming a tunnel silicon oxide layer, an N-type doped polysilicon layer, and a back passivated anti-reflection film on a back surface of an N-type silicon substrate; performing grooving on the back passivated anti-reflection film, and forming a nickel metal layer in a grooved region; printing a back fine gate electrode on the nickel metal layer, and printing a back main gate electrode on the back passivated anti-reflection film, wherein the back fine gate electrode is electrically connected to the back main gate electrode.

## Description

### Cross Reference to Related Applications

The application claims priority to CN Patent Application No. 202111396218.X, entitled "Solar Cell and Preparation Method for Solar Cell", which was filed on November 23, 2021, and the contents of which are hereby incorporated by reference in its entirety to serve as part or all of the application.

### Technical Field

The disclosure relates to a solar cell and a preparation method for a solar cell.

### Background

In PERC (Passivated Emitter and Rear Cell) solar cells, a silicon oxide layer is used to passivate a back surface of a silicon substrate, local openings realize a point contact to reduce the area of the non-passivated region, and by means of a local metal contact, the recombination speed of the back surface is greatly reduced, while the light reflection on the back surface is improved, and the conversion efficiency of the solar cells is increased. In passivated contact solar cells (such as TOPCon (Tunnel Oxide Passivated Contact) solar cells), a passivated contact structure composed of a tunnel silicon oxide layer and a doped polysilicon layer is used, which may effectively reduce surface recombination and metal contact recombination, and increase the cell conversion efficiency.

Since a silver metal has the advantages such as good conductivity, a low work function, good solderability, and difficulty in forming deep-level defects in silicon, both the PERC solar cells and the passivated contact solar cells use a silver paste to achieve metallization. However, due to the low content of silver in the earth crust and the comparatively high price thereof, the manufacturing cost of the solar cells is comparatively high. Meanwhile, it is generally required to corrode part of the silicon by the glass frit in the silver paste to form an ohmic contact, so a comparatively large junction depth of the diffusion is required, and if being used to passivate contact cells, a comparatively thick polysilicon layer is required. If an aluminum paste is used in place of the silver paste to reduce the cost, it can hardly ensure that a thin polysilicon layer is not damaged when the glass frit in the aluminum paste reacts with the silicon under a high temperature condition. However, a comparatively thick polysilicon layer not only increases the manufacturing cost of the solar cells, but also increases the parasitic light absorption, reduces the light utilization efficiency, and limits the efficiency of the solar cells.

### Summary

In view of this, the technical problem to be solved by the disclosure lies in providing a solar cell and a preparation method for a solar cell.

In order to achieve the aforesaid object, the disclosure provides the following technical solutions:
According to a first aspect, the disclosure provides a preparation method for a solar cell, comprising:
step 101: sequentially forming a tunnel silicon oxide layer, an N-type doped polysilicon layer, and a back passivated anti-reflection film on a back surface of an N-type silicon substrate;
step 102: performing grooving on the back passivated anti-reflection film, and forming a nickel metal layer in a grooved region;
step 103: printing a back fine gate electrode on the nickel metal layer, and printing a back main gate electrode on the back passivated anti-reflection film, wherein the back fine gate electrode is electrically connected to the back main gate electrode.

According to one or more embodiments of the disclosure, the step 103 comprises:
step 3-1: printing the back fine gate electrode on the nickel metal layer, and performing a first drying process, wherein the temperature of the first drying process is in a range of 100-300°C;
step 3-2: printing the back main gate electrode on the back passivated anti-reflection film, and performing a second drying process, wherein the temperature of the second drying process is in a range of 100-250°C.

According to one or more embodiments of the disclosure, the back fine gate electrode is made of an aluminum metal, and the back main gate electrode is made of a silver metal.

According to one or more embodiments of the disclosure, before the step 101, the method further comprises:
sequentially subjecting the back surface of the N-type silicon substrate to a texturing process and a polishing process.

According to one or more embodiments of the disclosure, the step 101 comprises:
step 1-1: forming the tunnel silicon oxide layer on the back surface of the N-type silicon substrate;
step 1-2: forming an intrinsic polysilicon layer on the tunnel silicon oxide layer;
step 1-3: subjecting the intrinsic polysilicon layer to N-type doping to form the N-type doped polysilicon layer;
step 1-4: forming the back passivated anti-reflection film on the N-type doped polysilicon layer.

According to one or more embodiments of the disclosure, the method further comprises:
step 104: subjecting a front surface of the N-type silicon substrate to a boron diffusion process to form a P+ emitter;
step 105: forming a front passivated anti-reflection film on the front surface of the N-type silicon substrate, the front passivated anti-reflection film covering the P+ em itter;
step 106: printing a front metal electrode on the front passivated anti-reflection film.

According to one or more embodiments of the disclosure, after the step 104, the method further comprises:
subjecting the front surface of the N-type silicon substrate to winding plating cleaning.

According to one or more embodiments of the disclosure, the back passivated anti-reflection film includes at least one of aluminum oxide, silicon oxide, gallium oxide, silicon nitride, aluminum nitride, and silicon oxynitride, and the front passivated anti-reflection film includes at least one of aluminum oxide, silicon oxide, gallium oxide, silicon nitride, aluminum nitride, and silicon oxynitride.

According to one or more embodiments of the disclosure, the step 102 comprises:
step 2-1: performing grooving on the back passivated anti-reflection film, and forming the nickel metal layer in the grooved region;
step 2-2, subjecting the nickel metal layer to a first annealing process to form a nickel-silicon alloy layer between the nickel metal layer and the N-type doped polysilicon layer; wherein the temperature of the annealing process is in a range of 200-400°C, and the time of the annealing process is in a range of 10 s-300 s.

According to a second aspect of the present disclosure, the embodiment of the disclosure provides a solar cell, which is prepared by the preparation method provided according to the aforesaid first aspect.

### Brief Description of the Drawings

FIG. 1 is a schematic diagram of a flow of a preparation method for a solar cell according to the disclosure;
FIG. 2 shows a structural diagram of a solar cell after a front metal electrode is prepared;
FIG. 3 shows a structural diagram of a solar cell after grooving is performed on a back passivated anti-reflection film;
FIG. 4 shows a structural diagram of a solar cell after a nickel metal layer is formed;
FIG. 5 shows a pattern of a back fine gate electrode;
FIG. 6 shows a schematic diagram of a solar cell after a back fine gate electrode and a back main gate electrode are formed;
FIG. 7 shows patterns a back fine gate electrode and a back fine gate electrode; and
FIG. 8 is a schematic diagram of a flow of a further preparation method for a solar cell according to the disclosure.

Reference signs are as follows:
1-N-type silicon substrate; 2-tunnel silicon oxide layer; 3-intrinsic polysilicon layer; 4-N-type doped polysilicon layer; 5-back passivated anti-reflection film; 6-nickel metal layer; 7-back metal electrode; 7a-back fine gate electrode; 7b-back main gate electrode; 8-P+ emitter; 9-front passivated anti-reflection film; 10-front metal electrode.

### Detailed Description

In the disclosure, an ohmic contact refers to a contact between a metal and a semiconductor, and the resistance value of the contact surface is much smaller than the resistance of the semiconductor itself, so that when a component is operated, most of the voltages drop in the active area rather than at the contact surface. In the application, the ohmic contact refers to the ohmic contact between the back fine gate electrode and the N-type doped polysilicon layer.

As mentioned above, in the process of using a silver paste to prepare a metal electrode, the glass body in the silver paste easily penetrates a comparatively thin polysilicon layer, so a comparatively thick polysilicon film is required to be used in the existing method, which increases the manufacturing cost of the solar cells, and also increases the parasitic light absorption and reduces the light utilization efficiency.

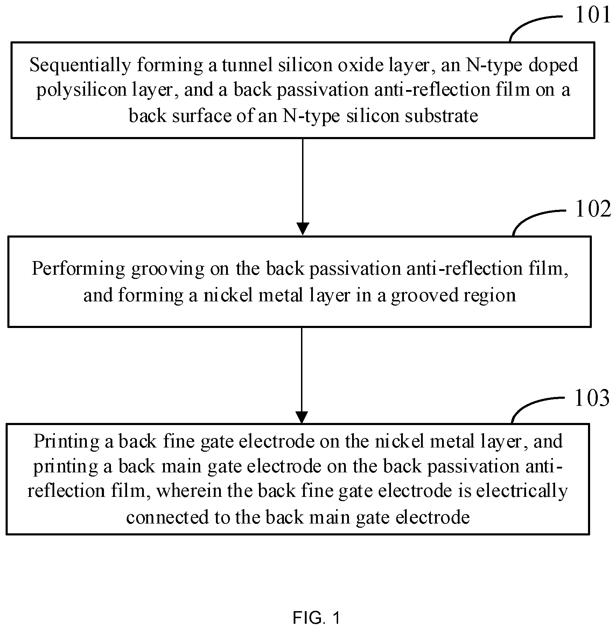

In order to solve the above problem, the embodiment of the disclosure provides a preparation method for a solar cell. Wherein FIG. 1 is a schematic diagram of a main flow of a preparation method for a solar cell. As show in FIG. 1, the preparation method for a solar cell may comprise the following steps:
step 101: sequentially forming a tunnel silicon oxide layer 2, an N-type doped polysilicon layer 4, and a back passivated anti-reflection film 5 on a back surface of an N-type silicon substrate 1;
step 102: performing grooving on the back passivated anti-reflection film 5, and forming a nickel metal layer 6 in a grooved region;
step 103: printing a back fine gate electrode 7a on the nickel metal layer 6, and printing a back main gate electrode 7b on the back passivated anti-reflection film 5, wherein the back fine gate electrode 7a is electrically connected to the back main gate electrode 7b.

Wherein, the front surface of the N-type silicon substrate 1 refers to the surface of the N-type silicon substrate facing towards the sunlight after the N-type silicon substrate is used to manufacture a solar cell, that is, the light-receiving surface of the N-type silicon substrate that receives sunlight. On the contrary, the back surface of the N-type silicon substrate 1 refers to the surface facing away from the sunlight, that is, the backlit surface opposite to the light-receiving surface of the N-type silicon substrate 1.

Before the step 101, the specific implementation scheme may further comprise:
sequentially subjecting the back surface of the N-type silicon substrate 1 to a texturing process and a polishing process. Specifically, a pyramid-like structure or a honeycomb-like structure is formed on the back surface of the N-type silicon substrate 1 after the texturing process. In the treatment of the solar cell surfaces, texturing is a process in which the surface of the silicon substrate is pre-cleaned and corroded with a strong alkaline or a strong acid to form a pyramid-like or honeycomb-like structure. The texturing may not only serve the purpose of reducing the reflectivity of the surface and removing the damaged layer, but also serve the purpose of forming a light trap (an anti-reflection texture) inside the cell, which, with the use of the light trapping principle, increases the effective length of the light movement inside the silicon substrate, and facilitates the absorption of light by the silicon substrate, thereby increasing the conversion efficiency of the solar cells. After the back surface of the N-type silicon substrate 1 is subjected to the texturing process, the back surface of the N-type silicon substrate 1 is subjected to the polishing process. The polishing process is just to subject the pyramid-like structure or honeycomb-like structure formed after subjecting the N-type silicon substrate 1 to the texturing process to a smoothing process to promote the passivation of the crystalline silicon surface on the back surface of the N-type silicon substrate 1 to thereby increase the cell efficiency. In a preferred embodiment, while the back surface of the N-type silicon substrate 1 is subjected to the texturing process, the front surface of the N-type silicon substrate 1 may also be subjected to the texturing process.

Further, according to the embodiment of the disclosure, the aforesaid method further comprises:
step 104: subjecting a front surface of the N-type silicon substrate 1 to a boron diffusion process to form a p-n junction to obtain a P+ emitter 8.

The specific embodiment may comprise: after subjecting the front surface of the N-type silicon substrate 1 to the texturing process, subjecting the front surface of the N-type silicon substrate 1 to the boron diffusion process to form the p-n junction to obtain the P+ emitter 8. A winding plating phenomenon will occur in the process, and part of the p-n junction and borosilicate glass will be formed on the back surface of the N-type silicon substrate 1, so after the P+ emitter 8 is formed on the front surface of the N-type silicon substrate 1, it is required to remove the p-n junction and borosilicate glass on the back surface of the N-type silicon substrate 1 by an HF solution.

With respect to the aforesaid step 101, the specific embodiment may comprise:
step 1-1: forming the tunnel silicon oxide layer 2 on the back surface of the N-type silicon substrate 1. Wherein, the thickness of the tunnel silicon oxide layer 2 is an arbitrary value in a range of 1-2 nm, such as 1.0 nm, 1.2 nm, 1.5 nm, 1.8 nm, and 2.0 nm. Based on the quantum tunneling effect, since the tunnel silicon oxide layer with this thickness is comparatively thin, carriers in the silicon substrate may pass through this layer and be collected. In one embodiment, the tunnel silicon oxide layer 2 may be formed by a high-temperature thermal oxidation method, a nitric acid oxidation method, an ozone oxidation method, or a CVD (Chemical Vapor Deposition) method. Specifically, when the tunnel silicon oxide layer 2 is formed by means of deposition on the back surface of the N-type silicon substrate 1 by the high-temperature thermal oxidation method, the deposition temperature is in a range of 500-700°C. In a preferred embodiment, the tunnel silicon oxide layer 2 is formed on the P+ emitter 8 formed on the front surface of the N-type silicon substrate 1 at the same time, so as to prevent the P+ emitter on the front surface from being contaminated when the N-type doped polysilicon layer 4 is subsequently formed on the back surface of the N-type silicon substrate 1.
step 1-2: forming an intrinsic polysilicon layer 3 on the tunnel silicon oxide layer 2. Specifically, the intrinsic polysilicon layer 3 may be formed by LPCVD (Low Pressure Chemical Vapor Deposition) or PVD (Physical Vapor Deposition). The thickness of the intrinsic polysilicon layer 3 is an arbitrary value in a range of 120-200 nm, such as 120 nm, 150 nm, 180 nm, and 200 nm. Preferably, the thickness of the intrinsic polysilicon layer 3 is an arbitrary value in a range of 80-150 nm. The comparatively thin polysilicon layer may not only reduce the consumption of the deposition process to thereby reduce the cost, but also reduce the parasitic light absorption of the polysilicon layer to thereby increase the light utilization efficiency. In a preferred embodiment, the intrinsic polysilicon layer 3 is formed on the front surface of the N-type silicon substrate 1.
step 1-3: subjecting the intrinsic polysilicon layer 3 on the back surface of the N-type silicon substrate 1 to N-type doping to form the N-type doped polysilicon layer 4. Specifically, the intrinsic polysilicon layer 3 may be subjected to an N-type doping process in an ion implantation manner to form the N-type doped polysilicon layer 4. The N-type doping includes, for example, phosphorus doping; the silicon wafer may also be placed in a phosphorus diffusion furnace tube to be subjected to phosphorus diffusion at a diffusion temperature in a range of 700-900°C to form the N-type doped polysilicon layer 4 on the back surface. The passivated contact structure composed of the tunnel silicon oxide layer 2 and the N-type doped polysilicon layer 4 may effectively reduce surface recombination and metal contact recombination, and increase the cell conversion efficiency while ensuring the passage of carriers.

According to the embodiment of the disclosure, after the N-type doped polysilicon layer 4 is formed on the back surface of the N-type silicon substrate 1, the front surface of the N-type silicon substrate 1 is subjected to winding plating cleaning, and the intrinsic polysilicon layer formed on the front surface is removed by a strong alkaline solution; the tunnel silicon oxide layer 2; and then the tunnel silicon oxide layer 2 and borosilicate glass on the front surface are removed by an HF solution, wherein the strong alkaline solution may be a potassium hydroxide solution or a sodium hydroxide solution. The borosilicate glass on the front surface is produced in the process of subjecting the front surface of the N-type silicon substrate 1 to the boron diffusion process.
step 1-4: forming the back passivated anti-reflection film 5 on the N-type doped polysilicon layer 4. The back passivated anti-reflection film 5 includes at least one of aluminum oxide, silicon oxide, gallium oxide, silicon nitride, aluminum nitride, and silicon oxynitride.

Further, according to the embodiment of the disclosure, the aforesaid method further comprises:
step 105: forming a front passivated anti-reflection film 9 on the front surface of the N-type silicon substrate 1, the front passivated anti-reflection film 9 covering the P+ emitter 8.

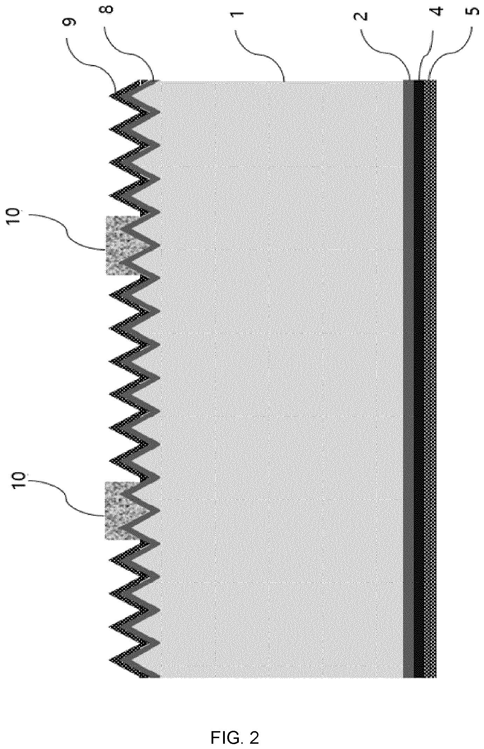

Specifically, the front passivated anti-reflection film 9 and the back passivated anti-reflection film 5 may be formed at the same time. The front passivated anti-reflection film 9 includes at least one of aluminum oxide, silicon oxide, gallium oxide, silicon nitride, aluminum nitride, and silicon oxynitride.
step 106: printing a front metal electrode 10 on the front passivated anti-reflection film 9, wherein FIG. 2 shows a structural diagram of a solar cell after a front metal electrode is prepared.

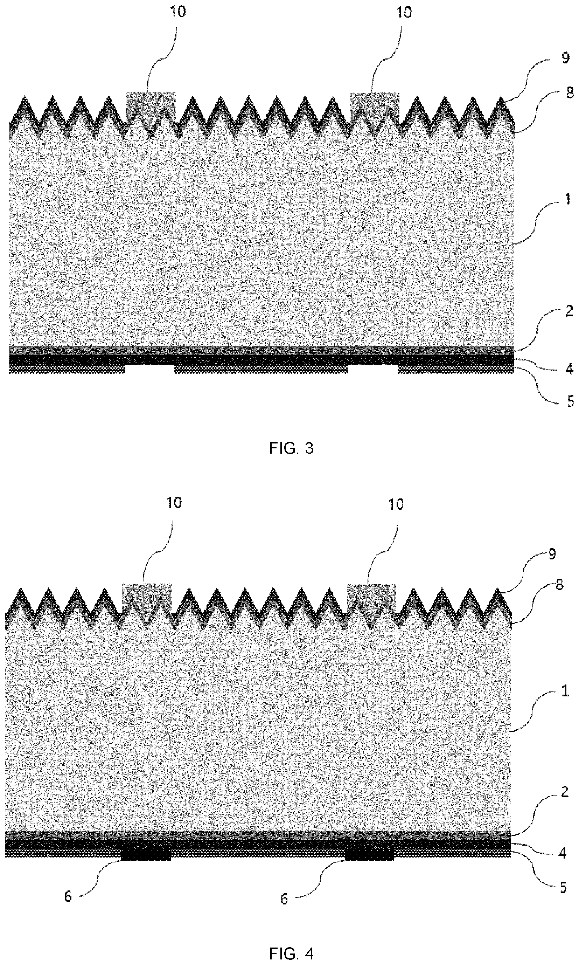

With respect to the aforesaid step 102, the specific implementation scheme may comprise:
step 2-1: performing grooving on the back passivated anti-reflection film 5, and forming the nickel metal layer 6 in the grooved region, wherein FIG. 3 shows a structural diagram of a solar cell after grooving is performed on a back passivated anti-reflection film; and FIG. 4 shows a structural diagram of a solar cell after a nickel metal layer is formed.
step 2-2, subjecting the nickel metal layer 6 to a first annealing process to form a nickel-silicon alloy layer between the nickel metal layer 6 and the N-type doped polysilicon layer 4; wherein the temperature of the annealing process is in a range of 200-400°C, and the time of the annealing process is in a range of 10 s-300 s.

In the step 102, a nickel-silicon alloy layer is formed by nickel and silicon to enhance a bonding force between a metal gate line and silicon, which helps to ensure that the N-type doped polysilicon layer is not damaged in the subsequent process of preparing the metal electrode by printing a paste so as to ensure the passivation effect of the passivated contact structure.

With respect to the aforesaid step 2-1, the specific implementation scheme may comprise:
First, grooving is performed on the back passivated anti-reflection film 5 by an ultraviolet picosecond laser with a wavelength of 355 nm, a conductive nickel paste is inject-printed in the grooved region by inkjet technology (inkjet printing technology), or the nickel metal layer 6 is formed in the grooved region by electroplating technology, then an annealing process is performed, and during the annealing process, the nickel-silicon alloy layer is formed between the nickel metal layer 6 and the N-type doped polysilicon layer 4. Wherein, the formed nickel-silicon alloy layer may increase the bonding force between the metal gate line and the silicon, the annealing temperature is in a range of 200-400°C, and the annealing time is in a range of 10 s-300 s; in a preferred embodiment, the annealing temperature is in a range of 250-350°C, the annealing time is in a range of 30 s-120 s, and the thickness of the nickel-silicon alloy layer is in a range of 10-30 nm. Performing grooving on the back passivated anti-reflection film 5 by the ultraviolet picosecond laser effectively reduces the damage to the back passivated anti-reflection film 5 in the grooving process.

With respect to the aforesaid step 103, the specific implementation scheme may comprise:
step 3-1: printing the back fine gate electrode 7a on the nickel metal layer 6, and performing a first drying process, wherein the temperature of the first drying process is in a range of 100-300°C;
step 3-2: printing the back main gate electrode 7b on the back passivated anti-reflection film 5, and performing a second drying process, so that the back main gate electrode 7b is electrically connected to the back fine gate electrode 7a, wherein the temperature of the second drying process is in a range of 100-250°C.

Specifically, the back fine gate electrode 7a is made of an aluminum metal, and the back main gate electrode 7b is made of a silver metal.

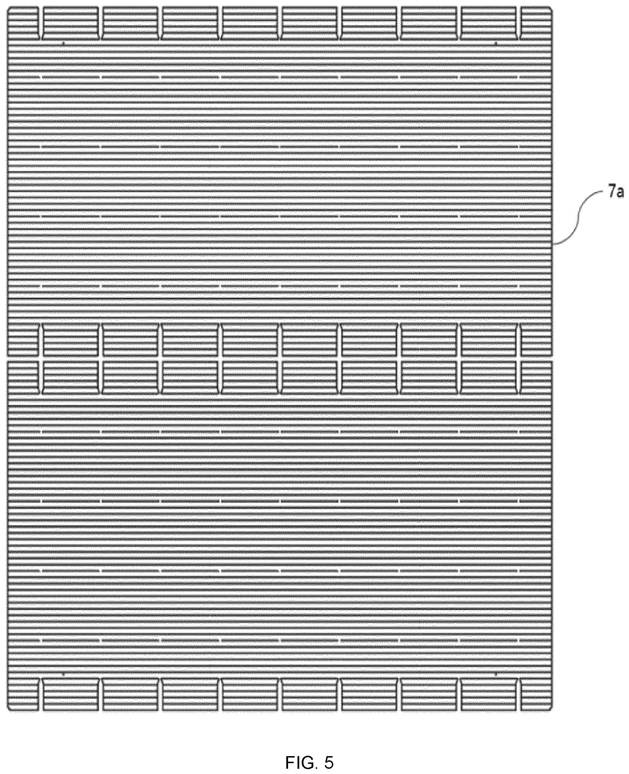

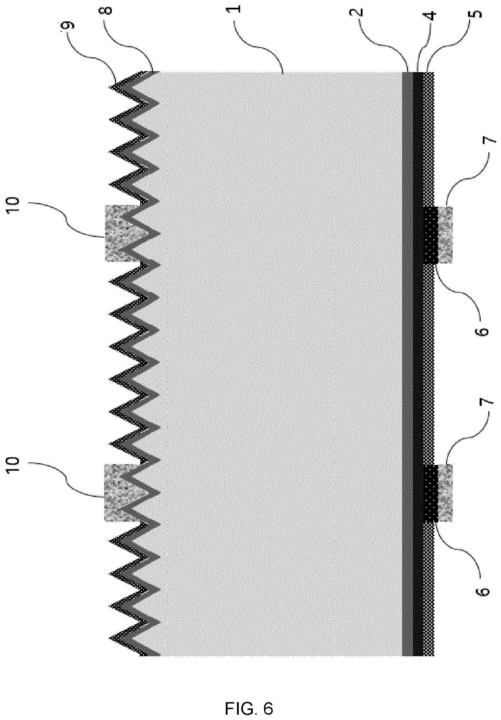

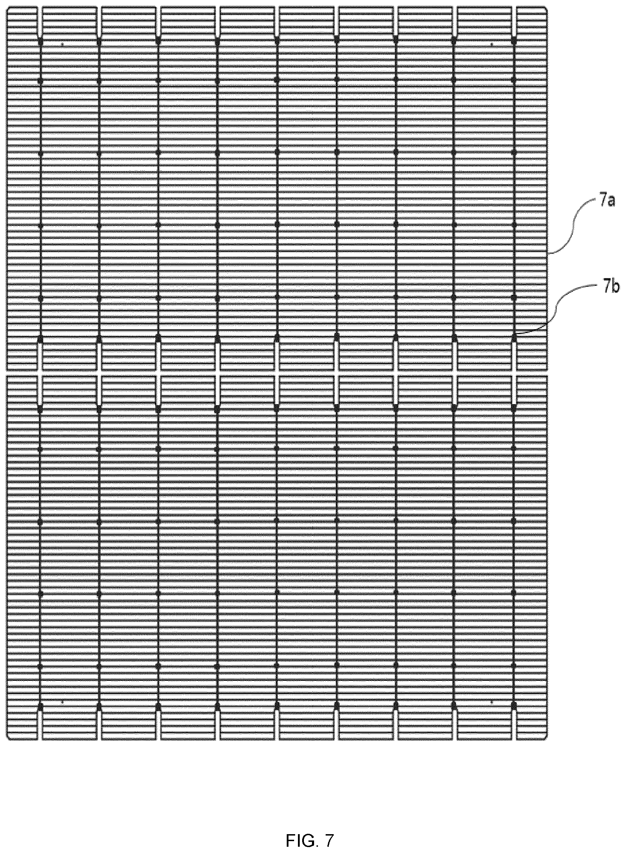

With respect to the aforesaid step 3-1 to the aforesaid step 3-2, the specific implementation scheme may comprise:
First, a low-temperature aluminum paste is printed on the nickel metal layer 6 and dried at a low temperature in a temperature range of 100-300°C to form the back fine gate electrode 7a, wherein FIG. 5 shows a pattern of a back fine gate electrode; then, a low-temperature silver paste is printed on the back passivated anti-reflection film 5 and dried at a low temperature in a temperature range of 100-250°C to form the back main gate electrode 7b, wherein the back main gate electrode 7b is electrically connected to the back fine gate electrode 7a, wherein FIG. 6 shows a schematic diagram of a solar cell after a back metal electrode (including a back fine gate electrode and a back main gate electrode) is formed; and FIG. 7 shows patterns a back fine gate electrode and a back fine gate electrode.

The preparation method for a solar cell provided by the embodiment of the disclosure sequentially forms a tunnel silicon oxide layer, an N-type doped polysilicon layer, and a back passivated anti-reflection film on a back surface of an N-type silicon substrate; then performs grooving on the back passivated anti-reflection film, and forms a nickel metal layer in a grooved region; and then prints a back fine gate electrode on the nickel metal layer, and prints a back main gate electrode on the back passivated anti-reflection film, wherein the back fine gate electrode is electrically connected to the back main gate electrode, thereby avoiding a damage to a comparatively thin polysilicon layer during the use of the paste while ensuring the bonding force between the metal gate line and the silicon, which ensures the passivation effect of the passivated contact structure, reduces the manufacturing cost of the solar cells, reduces the parasitic light absorption, increases the light utilization efficiency, and increases the efficiency of the solar cells.

Meanwhile, the back fine gate electrode is made of an aluminum metal, which further reduces the silver consumption required to prepare the back metal electrode, and effectively reduces the preparation cost of the solar cells.

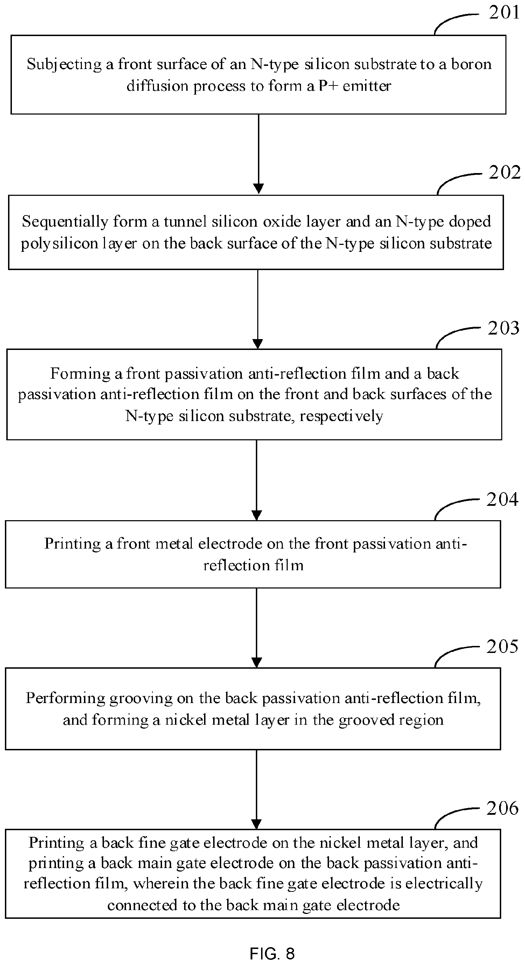

The embodiment of the disclosure further provides a preparation method for a solar cell. As shown in FIG. 8, the preparation method for a solar cell may comprise the following steps:
step 201: subjecting a front surface of an N-type silicon substrate 1 to a boron diffusion process to form a P+ emitter 8;
step 202: sequentially form a tunnel silicon oxide layer 2 and an N-type doped polysilicon layer 4 on the back surface of the N-type silicon substrate 1;
step 203: forming a front passivated anti-reflection film 9 and a back passivated anti-reflection film 5 on the front and back surfaces of the N-type silicon substrate 1, respectively; the front passivated anti-reflection film 9 covering the P+ emitter 8;
step 204: printing a front metal electrode 10 on the front passivated anti-reflection film 9;
step 205: performing grooving on the back passivated anti-reflection film 5, and forming a nickel metal layer 6 in the grooved region;
step 206: printing a back fine gate electrode 7a on the nickel metal layer 6, and printing a back main gate electrode 7b on the back passivated anti-reflection film 5, wherein the back fine gate electrode 7a is electrically connected to the back main gate electrode 7b.

Specifically, in an optional embodiment, before the step 201, the method further comprises: subjecting the front and back surfaces of the N-type silicon substrate 1 to a texturing process, and subjecting the back surface of the N-type silicon substrate 1 to a polishing process. In an optional embodiment, after the P+ emitter 8 is formed on the front surface of the N-type silicon substrate 1 in the step 201, it is required to remove the p-n junction and borosilicate glass on the back surface of the N-type silicon substrate 1 by an HF solution. In an optional embodiment, while the tunnel silicon oxide layer 2 and an intrinsic polysilicon layer 3 are formed on the back surface of the N-type silicon substrate 1, the tunnel silicon oxide layer 2 and the intrinsic polysilicon layer 3 are also formed on the front surface of the N-type silicon substrate 1; in a preferred embodiment, before the step 203, the intrinsic polysilicon layer 3 formed on the front surface of the N-type silicon substrate 1 is removed by a sodium hydroxide solution or a potassium hydroxide solution, and the tunnel silicon oxide layer and borosilicate glass on the front surface are removed by an HF solution.

Another aspect of the disclosure further comprises a solar cell prepared by the above preparation method for a solar cell. The solar cell comprises: an N-type silicon substrate 1, a tunnel silicon oxide layer 2, an N-type doped polysilicon layer 4, and a back passivated anti-reflection film 5 sequentially arranged from top to bottom; wherein,
a nickel metal layer 6 is formed in the grooved region of the back passivated anti-reflection film 5, and a back fine gate electrode 7a and a back main gate electrode 7b are formed on the nickel metal layer 6, wherein the back fine gate electrode 7a is electrically connected to the back main gate electrode are formed 7b.

Further, according to the embodiment of the disclosure, the front surface of the N-type silicon substrate 1 of the aforesaid solar cell is further sequentially provided with a P+ emitter 8, a front passivated anti-reflection film 9, and a front metal electrode 10.

In the disclosure, the aforesaid back fine gate electrode 7a is made of an aluminum metal, and the aforesaid back fine gate electrode 7a is made of a silver metal.

The preparation method for a solar cell provided by the disclosure and the solar cell obtained thereby are described in detail below with several specific embodiments.

### Embodiment 1

Step A1: Provide an N-type silicon substrate 1, subject the front and back surfaces of the N-type silicon substrate 1 to a texturing process, and subject the back surface of the N-type silicon substrate 1 to a polishing process.

Step B1: Subject the front surface of the N-type silicon substrate 1 to a boron diffusion process to form a P+ emitter 8.

Step C1: Remove a p-n junction and borosilicate glass on the back surface of the N-type silicon substrate 1 by an HF acid solution.

Step D1: Form a tunnel silicon oxide layer 2 with a thickness in a range of 1-2 nm on the back surface of the N-type silicon substrate 1 by a high-temperature thermal oxidation method.

Step E1: Form an intrinsic polysilicon layer 3 on the tunnel silicon oxide layer 2 on the back surface of the N-type silicon substrate 1 by LPCVD/PVD.

Step F1: Subject the intrinsic polysilicon layer 3 on the back surface to a doping process with a doping element phosphorus in an ion implantation manner, and perform an annealing process to form the N-type doped polysilicon layer 4, wherein the thickness of the N-type doped polysilicon layer is in a range of 80-200 nm.

Step G1: Remove the borosilicate glass on the front surface of the N-type silicon substrate 1 by an HF acid solution.

Step H1: Form a front passivated anti-reflection film 9 on the front surface of the N-type silicon substrate 1, and form a back passivated anti-reflection film 5 on the back surface of the N-type silicon substrate 1, wherein the front passivated anti-reflection film and the back passivated anti-reflection film are both at least one of aluminum oxide, silicon oxide, gallium oxide, silicon nitride, aluminum nitride, and silicon oxynitride.

Step 11: Prepare a front metal electrode 10 on the front passivated anti-reflection film 9.

Step J1: Perform grooving on the back passivated anti-reflection film 5 by an ultraviolet picosecond laser with a wavelength of 355 nm to obtain the structure as shown in FIG. 3, and then form a nickel metal layer 6 in the grooved region to obtain the structure as shown in FIG. 4.

Step K1: Subject the nickel metal layer 6 to a first annealing process to form a nickel-silicon alloy layer between the nickel metal layer 6 and the N-type doped polysilicon layer 4; wherein the temperature of the annealing process is in a range of 200-400°C, and the time of the annealing process is in a range of 10 s-300 s.

Step L1: Print an aluminum paste on the nickel metal layer 6, and perform a drying process in a range of 100-300°C to prepare the back fine gate electrode 7a;
Step M1: Print a silver paste on the back passivated anti-reflection film 5, and perform a drying process in a range of 100-250°C to prepare the back main gate electrode 7b to obtain the structure as shown in FIG. 6, wherein the back main gate electrode 7b is electrically connected to the back fine gate electrode 7a.

### Embodiment 2

Steps A2-C2 are the same as the steps A1-C1 provided in Embodiment 1.

Step D2: Form tunnel silicon oxide layers 2 with a thickness in a range of 1-2 nm on the back and front surfaces of the N-type silicon substrate 1, respectively by a high-temperature thermal oxidation method.

Step E2: Form intrinsic polysilicon layers 3 on the tunnel silicon oxide layers 2 on the back and front surfaces of the N-type silicon substrate 1 by LPCVD/PVD.

Step F2: Subject the intrinsic polysilicon layer 3 on the back surface to a doping process with phosphorus in an ion implantation manner, and perform an annealing process to form the N-type doped polysilicon layer 4, wherein the thickness of the N-type doped polysilicon layer is in a range of 80-200 nm.

Step G2: Remove the intrinsic polysilicon layer 3 on the front surface of the N-type silicon substrate 1 by a potassium hydroxide solution or a sodium hydroxide solution, and then remove the tunnel silicon oxide layer 2 and borosilicate glass on the front surface by an HF acid solution.

Step H2: Form a front passivated anti-reflection film 9 on the front surface of the N-type silicon substrate 1, and form a back passivated anti-reflection film 5 on the back surface of the N-type silicon substrate 1, wherein the front passivated anti-reflection film and the back passivated anti-reflection film are both at least one of aluminum oxide, silicon oxide, gallium oxide, silicon nitride, aluminum nitride, and silicon oxynitride.

Step I2: Prepare a front metal electrode 10 on the front passivated anti-reflection film 9.

Step J2: Perform grooving on the back passivated anti-reflection film 5 by an ultraviolet picosecond laser with a wavelength of 355 nm to obtain the structure as shown in FIG. 3, and then form a nickel metal layer 6 in the grooved region to obtain the structure as shown in FIG. 4.

Step K2: Subject the nickel metal layer 6 to a first annealing process to form a nickel-silicon alloy layer between the nickel metal layer 6 and the N-type doped polysilicon layer 4; wherein the temperature of the annealing process is in a range of 200-400°C, and the time of the annealing process is in a range of 10 s-300 s.

Step L2: Print an aluminum paste on the nickel metal layer 6, and perform a drying process in a range of 100-300°C to prepare the back fine gate electrode 7a;
Step M2: Print a silver paste on the back passivated anti-reflection film 5, and perform a drying process in a range of 100-250°C to prepare the back main gate electrode 7b to obtain the structure as shown in FIG. 6, wherein the back main gate electrode 7b is electrically connected to the back fine gate electrode 7a.

### Embodiment 3

The respective steps in this embodiment are the same as those in Embodiment 2, except that in step D3, tunnel silicon oxide layers 2 with a thickness in a range of 1-2 nm are formed on the back and front surfaces of the N-type silicon substrate 1 in a nitric acid oxidation manner.

### Embodiment 4

The respective steps in this embodiment are the same as those in Embodiment 2, except that in step F4, the silicon wafer is placed in a phosphorus diffusion furnace tube to be subjected to phosphorus diffusion at a diffusion temperature in a range of 700-900°C to form the N-type doped polysilicon layer 4 on the back surface.

The introductions provided by the above steps are only used to help understanding of the method, structure and main idea of the disclosure. Those skilled in the art may also make several improvements and modifications to the disclosure without departing from the principle of the disclosure, and these improvements and modifications also fall within the scopes of protection of the claims of the disclosure.

## Claims

1. A preparation method for a solar cell, comprising:
step 101: sequentially forming a tunnel silicon oxide layer (2), an N-type doped polysilicon layer (4), and a back passivated anti-reflection film (5) on a back surface of an N-type silicon substrate (1);
step 102: performing grooving on the back passivated anti-reflection film (5), and forming a nickel metal layer (6) in a grooved region;
step 103: printing a back fine gate electrode (7a) on the nickel metal layer (6), and printing a back main gate electrode (7b) on the back passivated anti-reflection film (5), wherein the back fine gate electrode (7a) is electrically connected to the back main gate electrode (7b).

2. The preparation method for a solar cell of claim 1, wherein the step 103 comprises:
step 3-1: printing the back fine gate electrode (7a) on the nickel metal layer (6), and performing a first drying process, wherein the temperature of the first drying process is in a range of 100-300°C;
step 3-2: printing the back main gate electrode (7b) on the back passivated anti-reflection film (5), and performing a second drying process, wherein the temperature of the second drying process is in a range of 100-250°C.

3. The preparation method for a solar cell of claim 2, wherein,
the back fine gate electrode (7a) is made of an aluminum metal, and the back main gate electrode (7b) is made of a silver metal.

4. The preparation method for a solar cell of claim 1, wherein before the step 101, the method further comprises:
sequentially subjecting the back surface of the N-type silicon substrate (1) to a texturing process and a polishing process.

5. The preparation method for a solar cell of claim 1, wherein the step 101 comprises:
step 1-1: forming the tunnel silicon oxide layer (2) on the back surface of the N-type silicon substrate (1);
step 1-2: forming an intrinsic polysilicon layer (3) on the tunnel silicon oxide layer (2);
step 1-3: subjecting the intrinsic polysilicon layer (3) to N-type doping to form the N-type doped polysilicon layer (4);
step 1-4: forming the back passivated anti-reflection film (5) on the N-type doped polysilicon layer (4).

6. The preparation method for a solar cell of claim 1, further comprising:
step 104: subjecting a front surface of the N-type silicon substrate (1) to a boron diffusion process to form a P+ emitter (8);
step 105: forming a front passivated anti-reflection film (9) on the front surface of the N-type silicon substrate (1), the front passivated anti-reflection film (9) covering the P+ emitter (8);
step 106: printing a front metal electrode (10) on the front passivated anti-reflection film (9).

7. The preparation method for a solar cell of claim 6, wherein after the step 104, the method further comprises:
subjecting the front surface of the N-type silicon substrate (1) to winding plating cleaning.

8. The preparation method for a solar cell of claim 6, wherein,
the back passivated anti-reflection film (5) includes at least one of aluminum oxide, silicon oxide, gallium oxide, silicon nitride, aluminum nitride, and silicon oxynitride, and the front passivated anti-reflection film (9) includes at least one of aluminum oxide, silicon oxide, gallium oxide, silicon nitride, aluminum nitride, and silicon oxynitride.

9. The preparation method for a solar cell of claim 1, wherein the step 102 comprises:
step 2-1: performing grooving on the back passivated anti-reflection film (5), and forming the nickel metal layer (6) in the grooved region;
step 2-2, subjecting the nickel metal layer (6) to a first annealing process to form a nickel-silicon alloy layer between the nickel metal layer (6) and the N-type doped polysilicon layer (4); wherein the temperature of the annealing process is in a range of 200-400°C, and the time of the annealing process is in a range of 10 s-300 s.

10. A solar cell, prepared by the preparation method of any of claims 1-9.
